# EUROPÄISCHE PATENTSCHRIFT

(11) **EP 3 581 685 B1**
(45) Veröffentlichungstag und Bekanntmachung des Hinweises auf die Patenterteilung: **02.11.2022**
(21) Anmeldenummer: 19178473.5
(22) Anmeldetag: 05.06.2019
(51) Int. Cl.: C25D 17/00, C25D 21/12, G01R 19/08

(54) **VERFAHREN UND VORRICHTUNG ZUR AUTOMATISIERTEN REGELUNG DER STRÖME IN EINEM GALVANIKBAD**
METHOD AND DEVICE FOR AUTOMATED CONTROL OF THE FLOWS IN A GALVANIC BATH
PROCÉDÉ ET DISPOSITIF DE RÉGLAGE AUTOMATISÉ DES FLUX DANS UN BAIN GALVANIQUE

(30) Priorität: 13.06.2018 DE 102018004841
(43) Veröffentlichungstag der Anmeldung: 18.12.2019
(73) Patentinhaber: Mahdjour, Hooshiar, 10589 Berlin (DE); Mahdjour, Kian, 10553 Berlin (DE)
(72) Erfinder: Mahdjour, Hooshiar, 10589 Berlin (DE); Mahdjour, Kian, 10553 Berlin (DE)
(74) Vertreter: Patentanwälte Bressel und Partner mbB

(56) Entgegenhaltungen:
- WO-A1-2006/027311
- WO-A2-2009/040250
- DE-B4-102012 014 985
- DE-U1-202007 015 737
- JP-B2- 3 575 897

## Beschreibung

Die vorliegende Erfindung betrifft eine Vorrichtung und ein Verfahren zur automatisierten Regelung der Ströme in einem Galvanikbad.

Unter Galvanotechnik sind alle Verfahren zur Oberflächenbehandlung von Metallen und Nichtmetallen zu verstehen, die zur Herstellung metallischer Überzüge aus Elektrolytlösungen und Salzschmelzen durch den Transport von Ionen und Elektronen und derer elektrochemischen Reduktion auf einer Oberfläche dienen. Dabei spielt die Stromdichteverteilung am Bauteil eine entscheidende Rolle, da hierdurch die Schichtdicke des metallischen Überzugs entscheidend beeinflusst wird. In der Praxis wird daher mittels Blendentechnik und Anodengeometrie angestrebt, eine über die Oberfläche möglichst homogene Stromdichteverteilung zu erreichen. Die Auswirkung von Änderungen an diesem System kann jedoch über eine Änderung der Schichtdickenverteilung nachgewiesen werden. Die Schichtverteilung kann von den prozessführenden Beschichtern, daher nicht genau prognostiziert werden. Eine Simulation der Feldverteilung ist zu aufwändig und teuer. Deshalb ist es Stand der Technik, die Blenden und/oder Anoden der Anordnung anhand von Erfahrungswerten zu positionieren.

In der Praxis hat dies zur Folge, dass auf einem zu beschichtenden Bauteil in vielen Bereichen zu viel oder zu wenig Material abgeschieden wird. Üblicherweise soll bei der Beschichtung eine Mindestschichtdicke vorgeschrieben werden, welche auch an den Stellen mit der geringsten Stromdichte erreicht wird. Daraus folgt eine in weiten Bereichen zu hohe oder zu niedrige Schichtdicke und die Schichtdicke ist über das gesamte Bauteil betrachtet inhomogen. Die zu hohe und inhomogene Schichtdicke ist u. a. aus folgenden Gründen nachteilig: Es entsteht zusätzlicher Materialbedarf (Metall, Chemie), zusätzlicher Energiebedarf und notwendige Nacharbeit. Eine zu niedrige Schichtdicke erfüllt die Beschichtungsanforderungen nicht.

Eine Möglichkeit die Positionierung der Blenden zu vereinfachen bietet die Echtzeitmessung der Stromdichte, denn die Auswirkung einer Veränderung der Stromdichte kann umgehend ermittelt werden. Dadurch kann die oben beschriebene Inhomogenität minimiert werden, was neben der besseren Ressourcennutzung und geringeren Nacharbeit auch Vorteile für die Gesamtqualität bietet (weniger Ausschuss) und die Produktionsfähigkeit der Produkte beschleunigt (weniger Musterteile). Es wird daher zur einfachen, schnellen und kostengünstigen Anoden- und Blendenoptimierung ein Messsystem benötigt, das einerseits die notwendigen Messwerte für lonenströme detektieren, andererseits in den handelsüblichen Elektrolyten und Bädern eingesetzt werden kann und daher über die notwendige chemische Beständigkeit und Handhabbarkeit verfügt.

In DE 10 2012 009 243 B3 wurde eine empfindliche und einsatzfähige Messsonde vorgeschlagen, mit deren Hilfe eine Echtzeitmessung der Stromdichte im Galvanikbad realisiert wurde. Es ist zwar möglich, wie in DE 10 2005 062 728 B4 beschrieben, solche Sonden mit einem Roboterarm im Galvanikbad zu steuern bzw. zu positionieren. Der Einsatz von Roboterarmen ist aber für große Werkstücke und in sehr großen Bädern sehr aufwändig. Aufwändig ist auch die Platzierung der Blenden.

Aus der JP 3 575897 B2 ist ein galvanisches Abscheidungsbeschichtungsverfahren bekannt, das eine gleichmäßige Beschichtung ermöglicht. Hierzu ist eine Potentialerfassungselektrode in elektrischem Kontakt mit dem Elektrolyten an einer bestimmten Stelle in der Nähe einer Arbeitselektrode angeordnet, um eine Gleichspannung an einer zu beschichtenden Elektrode zu bewirken. Ferner wird eine Spannungsquelle verwendet, die in der Lage ist, eine Ausgangsspannung derart zu steuern, dass die effektive Spannung einen vorgeschriebenen Wert erreicht, wenn die Spannung zwischen der Potentialerfassungselektrode und der zu beschichtenden Elektrode einen vorgeschriebenen Wert erreicht. Die galvanische Abscheidungsbeschichtung wird ausgeführt, während die effektive Spannung auf einen bestimmten Wert geregelt wird.

Aus der WO 2006/027311 A1 ist eine Elektrodenanordnung mit einer veränderlichen Geometrie zur Anpassung an ein zu behandelndes Bauteil bekannt. Die Behandlung des Bauteils kann aus einem elektrochemischen Beschichten oder Entschichten bestehen. Es ist vorgesehen, dass die Elektrodenanordnung Stabelektroden aufweist, die axial verschiebbar in einem Grundkörper gelagert sind. Damit lassen sich diese an das Profil der Oberfläche anpassen, wobei der Grundkörper einen mit Hartwachs gefüllten Hohlraum aufweist, der bei Verflüssigung des Hartwachses eine Axialverschiebung der Stabelektroden erlaubt und nach der Erstarrung des Hartwachses eine Fixierung der Stabelektroden ermöglicht. Die Elektrodenanordnung kann genutzt werden, um die elektrochemische Behandlung mit einer gleichmäßigen Stromdichteverteilung auf der Oberfläche durchzuführen.

Aus DE 20 2007 015 737 U1 ist eine Anordnung zur Echtzeitmessung der Stromdichte in einem Elektrolytbad bekannt, wobei die an der Kathode und Anode liegende Versorgungsspannung aus einer Konstantspannung besteht, die mit einer symmetrischen Wechselspannung überlagert ist.

Aus der WO 2009/040250 A2 ist eine Stromsteuerungsvorrichtung eines eine Anzahl von Anoden und eine Anzahl von Kathoden umfassenden Stromnetzes einer elektrochemischen Beschichtungsanlage bekannt, mit einer Mehrzahl von Steuerungsmodulen, wobei jedes Steuerungsmodul zur Bildung und Steuerung eines lokalen Stromflusses vorgegebener Größe als Funktion des Ortes und als Funktion der Zeit zwischen einer Anode und einer Kathode des Stromnetzes ausgebildet ist.

Der Erfindung liegt die Aufgabe zu Grunde, ein Verfahren und eine Vorrichtung zur automatisierten Regelung der Ströme in einem Galvanikbad zu verbessern.

### Erfindung

Die Aufgabe wird erfindungsgemäß durch eine Vorrichtung mit den Merkmalen des Patentanspruchs 1 oder des Patentanspruchs 6 und ein Verfahren mit den Merkmalen des Patentanspruchs 8 gelöst. Vorteilhafte Ausgestaltungen ergeben sich aus den Unteransprüchen.

Die vorliegende Erfindung betrifft eine Vorrichtung und ein Verfahren zur automatisierten Regelung der Stromdichte im flüssigen Elektrolyt des Galvanikbades, ohne Verwendung von Blenden, nach Anspruch 1, mithilfe einer Echtzeitmessung der Stromdichte an ausgewählten räumlichen Positionen im Galvanikbad und mithilfe von multiplen separat ansteuerbaren Gleichrichtern und Anoden. In EP 1 534 880 B1 ist bereits eine Anordnung mit ansteuerbaren Anoden vorgeschlagen, welche aber nur für bestimmte Anwendungen geeignet ist, nämlich zur Beschichtung großflächiger Substrate mit vergleichsweise hohen elektrischen Widerständen. Zudem handelt es sich hierbei nicht um eine unmittelbare Stromdichtemessung, sondern um Widerstandsmessung der zu beschichtenden Flächen. In DE 10 2012 014 985 B4 werden ein Verfahren und dessen Vorrichtung zur Überwachung von Galvanisierströmen beschrieben. Eine Regulierung der Ströme aus mehreren Gleichrichtern soll hier durch Einsatz von separaten Anoden und Gleichrichtern stattfinden. Auch hier wird nicht der ursächliche Parameter für inhomogene Beschichtungen gemessen und verwendet, nämlich die Stromdichte im flüssigen Elektrolyt des Galvanikbades, sondern lediglich der Ausgänge der sogenannten Durchsteck-Stromwandler, die die Ströme der Gleichrichter außerhalb des Galvanikbades messen. Zudem handelt es sich, im Falle ungleichmäßiger Beschichtungsprozesse, nicht um Ansteuerung der Anodenspannungen, sondern um Erzeugung von Alarmsignalen.

Erfindungsgemäß wird eine Vorrichtung zur automatisierten Regelung der Ströme in einem Galvanikbad geschaffen, mit
- mindestens einer zu beschichtenden Kathode im Galvanikbad,
- m ≥ 2 separaten ansteuerbaren Anoden im Galvanikbad,
- m ≥ 2 separaten Gleichrichtern zur Ansteuerung der Anoden,
- n ≥ 2 berührungslosen oder galvanisch getrennten Stromdichtesensoren im

Galvanikbad, wobei die Stromdichtesensoren zum Erfassen von lonenströmen durch eine Apertur jedes Stromdichtesensors und zum Erzeugen von zu den lonenströmen proportionalen Messsignalen i₁, i₂,..., iₙ eingerichtet sind,
- einer Stromdichtemesseinheit zur Erregung der Stromdichtesensoren und Verarbeitung deren Messsignale i₁, i₂, ..., iₙ und deren Lieferung an die zentrale Auswerte- und Steuereinheit,
- einer zentralen Auswerte- und Steuereinheit zur Auswertung der Werte der Messsignale i₁, i₂, ..., iₙ und Steuerung der Anodenansteuereinheit mittels der Ansteuersignale s₁, s₂, ..., sₘ,
- einer Anodenansteuereinheit zu individuellen und separaten Ansteuerungen der Gleichrichter, wobei
- die Stromdichtesensoren mithilfe eines Gitterrahmens mit mehreren Gitterstäben im Galvanikbad räumlich zwischen Kathode und Anoden stationär positioniert sind und
- ein Regelkreis aus der Stromdichtemesseinheit, der zentralen Auswerte- und Steuereinheit und der Anodenansteuereinheit zur Ansteuerung der Gleichrichter entsteht.

Gemäß einer Ausführungsform ist vorgesehen, dass die Gitterstäbe nicht auf der Ebene des Gitterahmens liegen und unterschiedliche, variierbare und einstellbare Längen und Winkel in Bezug auf den Gitterahmen aufweisen.

Gemäß einer alternativen Ausführungsform ist vorgesehen, dass sich die Stromdichtesensoren flexibel soweit rotieren lassen, dass Aperturflächen der Stromdichtesensoren parallel zu der Kathodenfläche gegenüber jedes einzelnen Stromdichtesensors positioniert werden können.

Gemäß einer weiteren alternativen Ausführungsform ist vorgesehen, dass die Stromdichtesensoren in ein elektrisch nichtleitendes Trägermedium eingebettet sind, wobei Aperturen der Stromdichtesensoren quadratisch sind.

Es ist vorgesehen, dass die Anzahl der Anoden und separaten Gleichrichter gleich sind.

Gemäß einer weiteren Ausführungsform ist vorgesehen, dass zwischen dem positiven Ausgang jedes Gleichrichters und dessen zugehörigen Anode eine Sperrdiode geschaltet ist, wobei der Anodenpol der Sperrdiode an dem positiven Ausgang des Gleichrichters angeschlossen ist und der Kathodenpol der Sperrdiode an der zugehörigen Anode angeschlossen ist.

Ferner wird insbesondere ein Verfahren zur automatisierten Regelung der Ströme in einem Galvanikbad mittels einer Vorrichtung nach einer der beschriebenen Ausführungsformen zur Verfügung gestellt, wobei am Prozessbeginn alle Anoden mit gleichen Spannungen beaufschlagt werden.

In einer Ausführungsform des Verfahrens ist vorgesehen, dass die Spannungen der Anoden sequenziell wiederholt in einer Schleife geändert werden, wobei nach jeder Änderung einer Anodenspannung die Messsignale i₁, i₂,.., iₙ der Stromdichtesensoren gemessen werden, und nach jeder Änderungsschleife der Einflussgrad jeder Anodenspannung auf jedes Messsignal i₁, i₂ ,.., iₙ bestimmt wird.

In einer weiterbildenden Ausführungsform des Verfahrens ist vorgesehen, dass die Anodenspannungen nach deren Einflussgrad auf die Messsignale i₁, i₂,.., iₙ angesteuert werden, damit sich die Messsignale i₁, i₂,.., iₙ annähern.

In einer Ausführungsform des Verfahrens ist vorgesehen, dass die sequenziellen schleifenartigen Änderungen der Anodenspannungen solange dauern, bis die Messsignale i₁, i₂,.., iₙ gleich groß sind, oder alternativ bis die paarweisen Differenzen der Messsignale i₁, i₂,.., iₙ innerhalb der angeforderten Homogenitätstoleranz liegen.

In einer alternativen Lösung wird insbesondere eine Vorrichtung zur automatisierten Regelung der Ströme in einem Galvanikbad geschaffen, mit
- mindestens einer zu beschichtenden Kathode im Galvanikbad,
- m ≥ 2 separaten ansteuerbaren Anoden im Galvanikbad,
- m ≥ 2 separaten Gleichrichtern zur Ansteuerung der Anoden,
- n ≥ 2 berührungslosen oder galvanisch getrennten Stromdichtesensoren im Galvanikbad,
- einer Stromdichtemesseinheit zur Erregung der Stromdichtesensoren und Verarbeitung deren Messsignale i₁, i₂, ..., iₙ und deren Lieferung an die zentrale Auswerte- und Steuereinheit,
- einer zentralen Auswerte- und Steuereinheit zur Auswertung der Werte der Messsignale i₁, i₂, ..., iₙ und Steuerung der Anodenansteuereinheit mittels der Ansteuersignale s₁, s₂, ..., sₘ,
- einer Anodenansteuereinheit zu individuellen und separaten Ansteuerungen der Gleichrichter, wobei
- die Stromdichtesensoren eingebettet in ein elektrisch nichtleitendes Trägermedium im Galvanikbad räumlich zwischen Kathode und Anoden stationär positioniert sind und
- ein Regelkreis aus der Stromdichtemesseinheit, der zentralen Auswerte- und Steuereinheit und der Anodenansteuereinheit zur Ansteuerung der Gleichrichter entsteht.

In einer Ausführungsform dieser alternativen Lösung ist vorgesehen, dass Aperturen der Stromdichtesensoren quadratisch sind.

Die Erfindung wird nachfolgend in Ausführungsformen und anhand der folgenden Zeichnungen erläutert.

Dabei zeigen:
- Fig. 1: Schematisches Grundkonzept der mechanischen Konstruktion der Vorrichtung
- Fig. 2: Schematisches Konzept zur flexiblen Positionierung der Stromdichtesensoren
- Fig. 3: Ausführungsbeispiel mit eingebetteten Stromdichtesensoren mit runden Aperturen in einem Trägermedium
- Fig. 4: Ausführungsbeispiel mit eingebetteten Stromdichtesensoren mit quadratischen Aperturen in einem Trägermedium
- Fig. 5: Architektur der Mess- und Steuereinheit

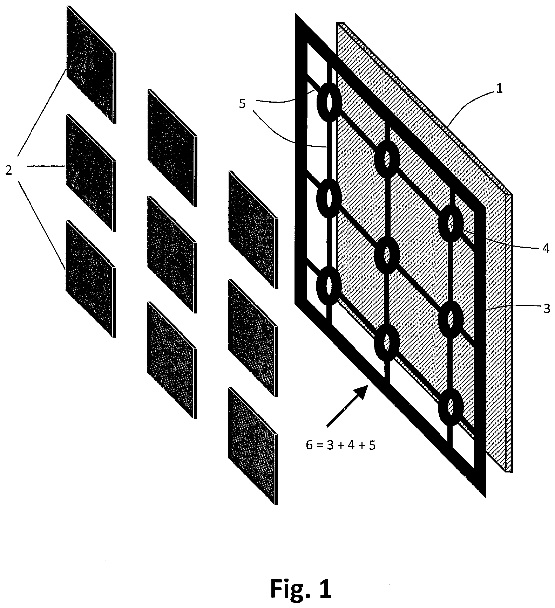

Fig. 1 zeigt ein Ausführungsbeispiel für das Grundkonzept der mechanischen Konstruktion der Vorrichtung der vorliegenden Erfindung, bestehend aus einer zu beschichtenden Kathode (Werkstück) 1, neun separat angesteuerten Anoden 2, einem Gitterrahmen 3, neun stationären berührungslosen bzw. galvanisch getrennten Stromdichtesensoren 4 und mehreren Gitterstäben 5. Dabei sind die Anoden 2 und die Kathode 1 der Übersichtlichkeit halber flach bzw. planar dargestellt. Die Anzahl der Anoden 2 ist variabel und hängt von den Maßen der Kathode 1 und des Galvanikbades 7 ab. Eine lonenströmung durch das Loch bzw. die Apertur jedes Stromdichtesensors 4 wird vom Stromdichtesensor erkannt und daraufhin wird ein Signal proportional zur elektrischen Stromstärke erzeugt (siehe Text unten). In dieser Schrift wird im Weiteren der Zusammenbau der Teile 3, 4 und 5 der Einfachheit halber als "Sensorgeflecht" 6 bezeichnet. Das Sensorgeflecht 6 wird in dem Raum zwischen der Kathode 1 und den Anoden 2 positioniert.

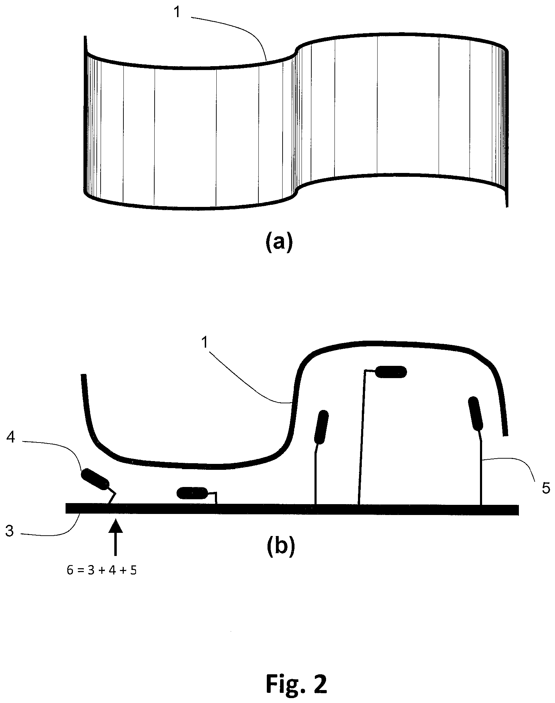

Für Anwendungen mit gebogenen bzw. 3-dimensional geformten Kathoden solle das Sensorgeflecht 6 eine flexible Einstellung und Positionierung der Stromdichtesensoren 4 ermöglichen. In Fig. 2a wird beispielsweise eine gebogene Kathode 1 dargestellt. Fig. 2b zeigt die Vogelperspektive der gebogenen Kathode 1 von Fig. 2a und des flexibel einstellbaren Sensorgeflechts 6. (Weil die Sichtrichtung von oben nach unten ist, sind die Aperturen der Stromdichtesensoren 4 nicht sichtbar). Die Gitterstäbe 5 liegen nicht auf der Ebene des Gitterrahmens 3, wie im Ausführungsbeispiel von Fig. 1, und weisen, nach Anspruch 2, unterschiedliche variierbare und einstellbare Längen und Winkel in Bezug auf den Gitterrahmen 3 auf. Zudem lassen sich die Stromdichtesensoren 4, nach Anspruch 3, flexibel soweit rotieren, dass die Aperturflächen der Stromdichtesensoren 4 parallel zu der Kathodenfläche gegenüber jedem Stromdichtesensor 4 positioniert werden können. Damit wird es ermöglicht, die Abstände der Stromdichtesensoren 4 zur Kathode 1 miteinander gleich einzustellen. Diese Einstellung ist sehr wichtig, weil die lonenstromstärke an einem Punkt im Galvanikbad vor allem abhängig von dessen kürzesten Abstand zur Kathode ist.

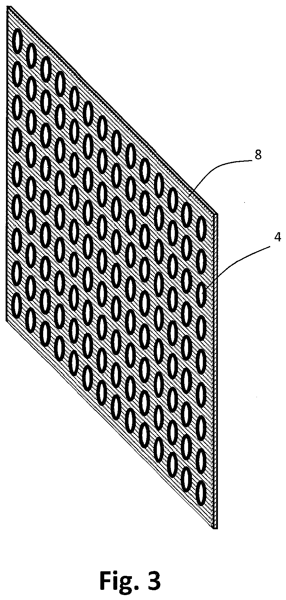

Bei manchen Anwendungen sind zahlreiche Stromdichtesensoren 4 einzusetzen, um die erforderlichen Messanforderungen zu erfüllen. In diesem Fall müssen, nach Anspruch 4, die Stromdichtesensoren 4 eng aneinander positioniert werden. Dazu wird ein anderer Zusammenbau des Sensorgeflechts 6, wie in Fig. 3 dargestellt, benötigt, der auf dem Konzept von Fig. 1 (bzw. von Anspruch 1), basiert. Dabei sind die runden Stromdichtesensoren 4 in ein elektrisch nichtleitendes Trägermedium 8 eingebettet. Das Trägermedium 8 weist hier die Funktion der Teile 3 und 5 in Fig. 1 auf. In diesem Ausführungsbeispiel besteht das Sensorgeflecht 6 aus den Teilen 4 und 8. In Trägermedium 8 sind praktisch der Gitterrahmen 3 und die Gitterstäben 5 eingebettet und integriert. Diese Form des Sensorgeflechts 6 vereinfacht dessen Herstellung. Das Trägermedium 8 soll nicht unbedingt, wie in Fig. 3, eine planare Form aufweisen. Für Anwendungen mit gebogenen bzw. 3-dimensional geformten Kathoden sollte das Trägermedium 8 am besten die gleiche Form aufweisen, wie die der Kathode 1, damit die kürzesten Abstände aller Stromdichtesensoren 4 zur Kathode 1 miteinander gleich werden.

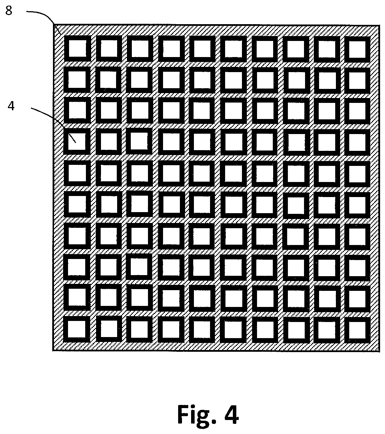

Um die mit lonenströmen nicht durchfließende Fläche zu reduzieren und folglich den Blendeneffekt des Trägermediums 8 zu reduzieren, können quadratische Stromdichtesensoren 4, nach Anspruch 5, wie in Fig. 4, eingesetzt werden.

Die Stromdichteverteilung im Galvanikbad ist abhängig von mehreren Faktoren und Parametern. Einer der wichtigsten Faktoren ist die geometrische Form der Kathode und der Anode. Der Grund dafür ist, dass die örtliche Stromdichte abhängig von den Feldlinien ist, die sich zwischen Anode und Kathode bilden. Diese Feldlinien konzentrieren sich an Spitzen, Ecken und Kanten eines Bauteils, während sich die Dichte der Feldlinien in Hohlräumen und Vertiefungen vermindert. Eine homogene Stromdichteverteilung lässt sich durch kontinuierliche Messung der Stromdichtewerte und gezielte Ansteuerung und Einstellung der an den Anoden angelegten Spannungen erreichen.

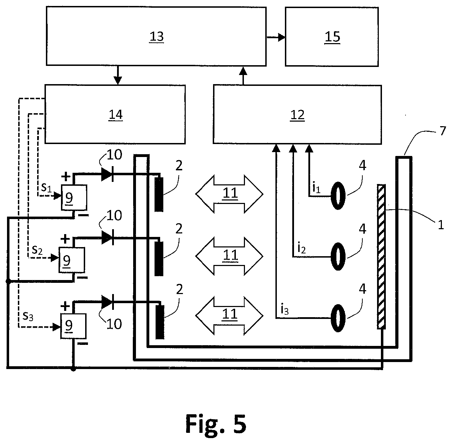

Fig. 5 zeigt die Architektur der Mess- und Steuereinheit zur Realisierung einer automatisierten Regelung der Stromdichteverteilung. Das Galvanikbad 7 enthält drei Stromdichtesensoren 4 und drei separat ansteuerbare Anoden 2, welche separat von den Gleichspannungen der drei Gleichrichter 9 angesteuert werden. Es dürfen, je nach Maß der Galvanikteile, auch andere Anzahlen für die Anoden 2 und die Stromdichtesensoren 4 verwendet werden. Die Hauptsache ist, dass die Anzahl der Anoden 2, Gleichrichter 9 und Stromdichtesensoren 4 jeweils ≥ 2 sein muss. Die Anzahl der Anoden ist, nach Anspruch 6, gleich der Anzahl der Gleichrichter. Die Anzahl der Stromdichtesensoren 4 muss nicht gleich der Anzahl der Anoden bzw. der Gleichrichter sein. Haben die Anoden 2 kleine Abstände zu einander, kann es dazu führen, dass bei ungleichen Anodenspannungen die Ströme eher zwischen den Anoden 2 fließen als zwischen Anoden 2 und Kathode 1. Um dies zu verhindern, soll, nach Anspruch 7, eine Sperrdiode 10 zwischen dem positiven Ausgang jedes Gleichrichters 9 und dessen zugehörigen Anode 2 geschaltet sein, wobei der Anodenpol der Sperrdiode 10 an dem positiven Ausgang des Gleichrichters 9 angeschlossen ist und der Kathodenpol der Sperrdiode 10 an der zugehörigen Anode 2 angeschlossen ist. Die von den Stromdichtesensoren 4 erzeugten Messsignale i₁, i₂ und i₃, welche zu den durch die Aperturen fließenden lonenströmen 11 proportional sind, werden der Stromdichtemesseinheit 12 geliefert. Die Stromdichtemesseinheit 12 erregt die Stromdichtesensoren 4 und verarbeitet deren resultierende Messsignale (i₁, i₂ und i₃) und liefert diese, vorzugsweise mittels einer seriellen Schnittstelle, an die zentrale Auswerte- und Steuereinheit 13. Die zentrale Auswerte- und Steuereinheit 13 wertet die drei Werte der Stromdichten aus und berechnet die Ansteuersignale für die Anodenansteuereinheit 14, die wiederum die Gleichrichter 9 mit individuellen Ansteuersignalen s₁, s₂ und s₃ ansteuert und demzufolge sich deren Ausgangsspannungen ändern, so dass sich die detektierten Messsignale i₁, i₂ und i₃ annähern. Am Prozessbeginn werden alle Anoden 2, nach Anspruch 8, mit gleichen Spannungen beaufschlagt. Danach werden, nach Anspruch 9, die Anodenspannungen sequenziell und wiederholt in einer Schleife geändert, wobei nach jeder Änderung einer Anodenspannung die Messsignale i₁, i₂ und i₃ aller Stromdichtesensoren 4 gemessen werden und nach dem Ende jeder Änderungsschleife, der Einflussgrad jeder Anodenspannung auf jedes Messsignal i₁, i₂ und i₃ bestimmt und registriert wird. Die Ansteuerungen der Anodenspannungen erfolgen mittels der drei Ansteuersignale s₁, s₂ und s₃, wobei deren Werte von der zentralen Auswerte- und Steuereinheit 13 bestimmt werden. Danach werden, nach Anspruch 10, nach dem Ende jeder Änderungsschleife, die Einflussgrade jeder Anodenspannung auf jedes Messsignal i₁, i₂ und i₃ analysiert, um festzustellen, welcher Wert für jede Anodenspannung einzustellen ist, damit sich die Messsignale i₁, i₂ und i₃ annähern. Der Prozess dauert, nach Anspruch 11, solange an, bis die drei Messsignale i₁, i₂ und i₃ gleich groß sind, oder alternativ bis die paarweisen Differenzen der Messsignale i₁, i₂ und i₃ innerhalb der angeforderten Toleranz liegen und somit die beabsichtigte Homogenität der Stromdichteverteilung erzielt wird. Diese Messungen, Auswertungen und Steuerungen müssen kontinuierlich bis zum Abschluss des Beschichtungsprozesses wiederholt werden, da nach Erreichung einer Homogenität der Stromdichteverteilung deren dauerhafte Erhaltung ohne ständige Regelung nicht garantiert werden kann. Im Prinzip handelt es sich um einen Regelkreis, dessen Endergebnisse mittels Ausgabeeinheit 15 ausgegeben und z. B. grafisch auf einem Display angezeigt werden können.

### Bezugszeichenliste

- 1: Kathode oder Werkstück
- 2: Anode
- 3: Gitterrahmen
- 4: Berührungsloser bzw. galvanisch getrennter Stromdichtesensor
- 5: Gitterstab
- 6: Sensorgeflecht = Zusammenbau der Teile (3), (4) und (5)
- 7: Galvanikbad
- 8: Trägermedium
- 9: Gleichrichter
- 10: Sperrdiode
- 11: lonenstrom
- 12: Stromdichtemesseinheit
- 13: zentrale Auswerte- und Steuereinheit
- 14: Anodenansteuereinheit
- 15: Ausgabeeinheit
- i₁, i₂, i₃: Messsignale aus den Stromdichtesensoren (4)
- s₁, s₂, s₃: Ansteuersignale von der zentralen Auswerte- und Steuereinheit (13)

## Patentansprüche

1. Vorrichtung zur automatisierten Regelung der Ströme in einem Galvanikbad mit
- mindestens einer zu beschichtenden Kathode (1) im Galvanikbad (7),
- m ≥ 2 separaten ansteuerbaren Anoden (2) im Galvanikbad (7),
- m ≥ 2 separaten Gleichrichtern (9) zur Ansteuerung der Anoden (2),
- n ≥ 2 berührungslosen oder galvanisch getrennten Stromdichtesensoren (4) im Galvanikbad (7), wobei die Stromdichtesensoren (4) zum Erfassen von lonenströmen (11) durch eine Apertur jedes Stromdichtesensors (4) und zum Erzeugen von zu den lonenströmen (11) proportionalen Messsignalen i₁, i₂, ..., iₙ eingerichtet sind,
- einer Stromdichtemesseinheit (12) zur Erregung der Stromdichtesensoren (4) und Verarbeitung deren Messsignale i₁, i₂, ..., iₙ und deren Lieferung an die zentrale Auswerte- und Steuereinheit (13),
- einer zentralen Auswerte- und Steuereinheit (13) zur Auswertung der Werte der Messsignale i₁, i₂, ..., iₙ und Steuerung der Anodenansteuereinheit (14) mittels der Ansteuersignale s₁, s₂, ..., sₘ,
- einer Anodenansteuereinheit (14) zu individuellen und separaten Ansteuerungen der Gleichrichter (9), wobei
- die Stromdichtesensoren (4) mithilfe eines Gitterrahmens (3) mit mehreren Gitterstäben (5) im Galvanikbad (7) räumlich zwischen Kathode (1) und Anoden (2) stationär positioniert sind und
- ein Regelkreis aus der Stromdichtemesseinheit (12), der zentralen Auswerte- und Steuereinheit (13) und der Anodenansteuereinheit (14) zur Ansteuerung der Gleichrichter (9) entsteht.

2. Vorrichtung nach Anspruch 1, wobei jeder Stromdichtesensor (4) mit einem der Gitterstäbe (5) verbunden ist, wobei die Gitterstäbe (5) nicht auf der Ebene des Gitterahmens (3) liegen und unterschiedliche, variierbare und einstellbare Längen und Winkel in Bezug auf den Gitterahmen (3) aufweisen.

3. Vorrichtung nach Anspruch 1, wobei sich die Stromdichtesensoren (4) flexibel soweit rotieren lassen, dass Aperturflächen der Stromdichtesensoren (4) parallel zu der Kathodenfläche gegenüber jedes einzelnen Stromdichtesensors (4) positioniert werden können.

4. Vorrichtung nach Anspruch 1, wobei die Stromdichtesensoren (4) in ein elektrisch nichtleitendes Trägermedium (8) eingebettet sind, wobei Aperturen der Stromdichtesensoren (4) quadratisch sind.

5. Vorrichtung nach einem der vorangegangenen Ansprüche, wobei zwischen dem positiven Ausgang jedes Gleichrichters (9) und dessen zugehöriger Anode (2) eine Sperrdiode (10) geschaltet ist, wobei der Anodenpol der Sperrdiode (10) an dem positiven Ausgang des Gleichrichters (9) angeschlossen ist und der Kathodenpol der Sperrdiode (10) an der zugehörigen Anode (2) angeschlossen ist.

6. Vorrichtung zur automatisierten Regelung der Ströme in einem Galvanikbad mit
- mindestens einer zu beschichtenden Kathode (1) im Galvanikbad (7),
- m ≥ 2 separaten ansteuerbaren Anoden (2) im Galvanikbad (7),
- m ≥ 2 separaten Gleichrichtern (9) zur Ansteuerung der Anoden (2),
- n ≥ 2 berührungslosen oder galvanisch getrennten Stromdichtesensoren (4) im Galvanikbad (7), wobei die Stromdichtesensoren (4) zum Erfassen von lonenströmen (11) durch eine Apertur jedes Stromdichtesensors (4) und zum Erzeugen von zu den lonenströmen (11) proportionalen Messsignalen i₁, i₂, ..., iₙ eingerichtet sind,
- einer Stromdichtemesseinheit (12) zur Erregung der Stromdichtesensoren (4) und Verarbeitung deren Messsignale i₁, i₂, ..., iₙ und deren Lieferung an die zentrale Auswerte- und Steuereinheit (13),
- einer zentralen Auswerte- und Steuereinheit (13) zur Auswertung der Werte der Messsignale i₁, i₂, ..., iₙ und Steuerung der Anodenansteuereinheit (14) mittels der Ansteuersignale s₁, s₂, ..., sₘ,
- einer Anodenansteuereinheit (14) zu individuellen und separaten Ansteuerungen der Gleichrichter (9), wobei
- die Stromdichtesensoren (4) eingebettet in ein elektrisch nichtleitendes Trägermedium (8) im Galvanikbad (7) räumlich zwischen Kathode (1) und Anoden (2) stationär positioniert sind und
- ein Regelkreis aus der Stromdichtemesseinheit (12), der zentralen Auswerte- und Steuereinheit (13) und der Anodenansteuereinheit (14) zur Ansteuerung der Gleichrichter (9) entsteht.

7. Vorrichtung nach Anspruch 6, wobei die Aperturen der Stromdichtesensoren (4) quadratisch sind.

8. Verfahren zur automatischen Regelung der Ströme in einem Galvanikbad mittels einer Vorrichtung nach einem der vorangegangenen Ansprüche, wobei am Prozessbeginn alle Anoden (2) mit gleichen Spannungen beaufschlagt werden.

9. Verfahren nach Anspruch 8, wobei die Spannungen der Anoden (2) sequenziell wiederholt in einer Schleife geändert werden, wobei nach jeder Änderung einer Anodenspannung die Messsignale i₁, i₂,.., iₙ der Stromdichtesensoren (4) gemessen werden, und nach jeder Änderungsschleife der Einflussgrad jeder Anodenspannung auf jedes Messsignal i₁, i₂ ,.., iₙ bestimmt wird.

10. Verfahren nach Anspruch 9, wobei die Anodenspannungen nach deren Einflussgrad auf die Messsignale i₁, i₂,.., iₙ angesteuert werden, damit sich die Messsignale i₁, i₂,.., iₙ annähern.

11. Verfahren nach einem der vorangegangenen Ansprüche 8 bis 10, wobei die sequenziellen schleifenartigen Änderungen der Anodenspannungen solange dauern, bis die Messsignale i₁, i₂,.., iₙ gleich groß sind, oder alternativ bis die paarweisen Differenzen der Messsignale i₁, i₂,.., iₙ innerhalb der angeforderten Homogenitätstoleranz liegen.

## Claims

1. Device for automated control of the currents in an electroplating bath with
- at least one cathode (1) to be coated in the electroplating bath (7),
- m ≥ 2 separate controllable anodes (2) in the electroplating bath (7),
- m ≥ 2 separate rectifiers (9) for controlling the anodes (2),
- n ≥ 2 contactless or galvanically isolated current density sensors (4) in the electroplating bath (7), wherein the current density sensors (4) are configured to detect ion currents (11) through an aperture of each current density sensor (4) and to generate measurement signals i₁, i₂, ..., iₙ proportional to the ion currents (11),
- a current density measuring unit (12) for excitation of the current density sensors (4) and processing of the measuring signals i₁, i₂, ..., iₙ supplying them to the central evaluation and control unit (13),
- a central evaluation and control unit (13) for evaluating the values of the measurement signals i₁, i₂, ..., iₙ and controlling the anode drive unit (14) by means of the drive signals s₁, s₂, ..., sₘ,
- an anode drive unit (14) for individual and separate excitation of the rectifiers (9),
wherein
- the current density sensors (4) are spatially embedded positioned between cathode (1) and anodes (2) in the electroplating bath (7) by a grid frame (3) with several grid rods (5), and
- a control loop by the current density measuring unit (12), the central evaluation and control unit (13) and the anode control unit (14) for excitation of the rectifiers (9) is formed.

2. Device according to claim 1, wherein each current density sensor (4) is connected to one of the grid bars (5), wherein the grid bars (5) are not on the same level as the grid frame (3) and have different, variable and adjustable lengths and angles in relation to the grid frame (3).

3. Device according to claim 1, wherein the current density sensors (4) are flexible to rotate to the extent that the aperture surfaces of the current density sensors (4) can be positioned parallel to the cathode surface opposite each current density sensor (4).

4. Device according to claim 1, wherein the current density sensors (4) are embedded in an electrically non-conductive carrier medium (8), wherein apertures of the current density sensors (4) are quadratic.

5. Device according to any one of the previous claims, wherein a blocking diode (10) is connected between the positive output of each rectifier (9) and its related anode (2), wherein the anode pole of the blocking diode (10) is connected to the positive output of the rectifier (9) and the cathode pole of the blocking diode (10) is connected to the related anode (2).

6. Device for automated control of the currents in an electroplating bath with
- at least one cathode (1) to be coated in the electroplating bath (7),
- m ≥ 2 separate controllable anodes (2) in the electroplating bath (7),
- m ≥ 2 separate rectifiers (9) for triggering the anodes (2),
- n ≥ 2 contactless or galvanically isolated current density sensors (4) in the electroplating bath (7), wherein the current density sensors (4) are configured to detect ion currents (11) through an aperture of each current density sensor (4) and to generate measurement signals i₁, i₂, ..., iₙ proportional to the ion currents (11),
- a current density measuring unit (12) for exciting of the current density sensors (4) and processing their measuring signals i₁, i₂, ..., iₙ and supplying them to the central evaluation and control unit (13),
- a central evaluation and control unit (13) for evaluating the values of the measurement signals i₁, i₂, ..., iₙ and controlling the anode drive unit (14) by means of the drive signals s₁, s₂, ..., sₘ,
- an anode drive unit (14) for individual and separate excitation of the rectifiers (9), wherein
- the current density sensors (4) are spatially embedded in an electrically non-conductive carrier medium (8) in a stationary position in the electroplating bath (7) between the cathode (1) and the anodes (2), and
- a control loop is created from the current density measuring unit (12), the central evaluation and control unit (13) and the anode control unit (14) for controlling the rectifiers (9).

7. Device according to claim 6, wherein the apertures of the current density sensors (4) are quadratic.

8. Method for automatic control of the currents in an electroplating bath by a device according to one of the previous claims, wherein at the start of the process all anodes (2) are subjected to the same voltages.

9. Method according to claim 8, wherein the voltages of the anodes (2) are sequentially changed repeatedly in a loop, wherein after each change of an anode voltage the measurement signals i₁, i₂,.., iₙ of the current density sensors (4) are measured, and after each change loop the degree of influence of each anode voltage on each measurement signal i₁, i₂,.., iₙ is determined.

10. Method according to claim 9, wherein the anode voltages are triggered depending on their degree of influence on the measurement signals i₁, i₂,.., iₙ, so that the measurement signals i₁, i₂,.., iₙ approach each other.

11. Method according to any one of the previous claims 8 to 10, wherein the sequential loop-like changes of the anode voltages last until the measurement signals i₁, i₂,.., iₙ are equal in magnitude, or alternatively until the pairwise differences of the measurement signals i₁, i₂,.., iₙ are within the requested homogeneity tolerance.

## Revendications

1. Dispositif pour la régulation automatisée des courants dans un bain de galvanisation avec
- au moins une cathode (1) à revêtir dans le bain de galvanisation (7),
- m ≥ 2 anodes (2) séparées pouvant être commandées dans le bain de galvanisation (7),
- m ≥ 2 redresseurs séparés (9) pour la commande des anodes (2),
- n ≥ 2 capteurs de densité de courant (4) sans contact ou isolés galvaniquement dans le bain de galvanisation (7), les capteurs de densité de courant (4) étant conçus pour détecter des courants ioniques (11) à travers une ouverture de chaque capteur de densité de courant (4) et pour générer des signaux de mesure i₁, i₂, ..., iₙ proportionnels aux courants ioniques (11),
- une unité de mesure de densité de courant (12) pour l'excitation des capteurs de densité de courant (4) et le traitement de leurs signaux de mesure i₁, i₂, ..., iₙ et leur livraison à l'unité centrale d'évaluation et de commande (13),
- une unité centrale d'évaluation et de commande (13) pour l'évaluation des valeurs des signaux de mesure i₁, i₂, ..., iₙ et la commande de l'unité de commande d'anode (14) au moyen des signaux de commande s₁, s₂, ..., sₘ,
- d'une unité de commande d'anode (14) pour des commandes individuelles et séparées des redresseurs (9), où
- les capteurs de densité de courant (4) sont positionnés de manière stationnaire dans l'espace entre la cathode (1) et les anodes (2) à l'aide d'un cadre de grille (3) avec plusieurs barres de grille (5) dans le bain de galvanisation (7) et
- un circuit de régulation est créé à partir de l'unité de mesure de la densité de courant (12), de l'unité centrale d'évaluation et de commande (13) et de l'unité de commande des anodes (14) pour la commande des redresseurs (9).

2. Dispositif selon la revendication 1, dans lequel chaque capteur de densité de courant (4) est relié à l'un des barreaux de grille (5), les barreaux de grille (5) n'étant pas situés dans le plan du cadre de grille (3) et ayant des longueurs et des angles différents, variables et réglables par rapport au cadre de grille (3).

3. Dispositif selon la revendication 1, dans lequel les capteurs de densité de courant (4) peuvent être tournés de manière flexible jusqu'à ce que les surfaces d'ouverture des capteurs de densité de courant (4) puissent être positionnées parallèlement à la surface cathodique opposée à chaque capteur de densité de courant individuel (4).

4. Dispositif selon la revendication 1, dans lequel les capteurs de densité de courant (4) sont noyés dans un milieu de support (8) non conducteur de l'électricité, les ouvertures des capteurs de densité de courant (4) étant carrées.

5. Dispositif selon l'une quelconque des revendications précédentes, dans lequel une diode de blocage (10) est connectée entre la sortie positive de chaque redresseur (9) et son anode associée (2), le pôle anodique de la diode de blocage (10) étant connecté à la sortie positive du redresseur (9) et le pôle cathodique de la diode de blocage (10) étant connecté à l'anode associée (2).

6. Dispositif pour la régulation automatisée des courants dans un bain de galvanisation avec
- au moins une cathode (1) à revêtir dans le bain de galvanisation (7),
- m ≥ 2 anodes (2) séparées pouvant être commandées dans le bain de galvanisation (7),
- m ≥ 2 redresseurs séparés (9) pour la commande des anodes (2),
- n ≥ 2 capteurs de densité de courant (4) sans contact ou isolés galvaniquement dans le bain de galvanisation (7), les capteurs de densité de courant (4) étant conçus pour détecter des courants ioniques (11) à travers une ouverture de chaque capteur de densité de courant (4) et pour générer des signaux de mesure i₁, i₂, ..., iₙ proportionnels aux courants ioniques (11),
- une unité de mesure de densité de courant (12) pour l'excitation des capteurs de densité de courant (4) et le traitement de leurs signaux de mesure i₁, i₂, ..., iₙ et leur livraison à l'unité centrale d'évaluation et de commande (13),
- une unité centrale d'évaluation et de commande (13) pour l'évaluation des valeurs des signaux de mesure i₁, i₂, ..., iₙ et la commande de l'unité de commande d'anode (14) au moyen des signaux de commande s₁, s₂, ..., sₘ,
- d'une unité de commande d'anode (14) pour des commandes individuelles et séparées des redresseurs (9), où
- les capteurs de densité de courant (4) sont positionnés de manière stationnaire dans l'espace entre la cathode (1) et les anodes (2) dans le bain de galvanisation (7), en étant noyés dans un milieu porteur (8) non conducteur de l'électricité, et
- un circuit de régulation est créé à partir de l'unité de mesure de la densité de courant (12), de l'unité centrale d'évaluation et de commande (13) et de l'unité de commande des anodes (14) pour la commande des redresseurs (9).

7. Dispositif selon la revendication 6, dans lequel les ouvertures des capteurs de densité de courant (4) sont carrées.

8. Procédé de régulation automatique des courants dans un bain de galvanisation au moyen d'un dispositif selon l'une des revendications précédentes, dans lequel, au début du processus, toutes les anodes (2) sont soumises à des voltages identiques.

9. Procédé selon la revendication 8, dans lequel les voltages des anodes (2) sont modifiées séquentiellement de manière répétée dans une boucle, dans lequel, après chaque modification d'une voltage d'anode, les signaux de mesure i₁, i₂, ..., iₙ dans les capteurs de densité de courant (4) sont mesurés, et après chaque boucle de modification, le degré d'influence de chaque voltage d'anode sur chaque signal de mesure i₁, i₂, ..., iₙ dans est déterminé.

10. Procédé selon la revendication 9, dans lequel les voltages d'anode sont commandées en fonction de leur degré d'influence sur les signaux de mesure i₁, i₂, ..., iₙ, afin que les signaux de mesure i₁, i₂, ..., iₙ se rapprochent.

11. Procédé selon l'une quelconque des revendications précédentes 8 à 10, dans lequel les modifications séquentielles en forme de boucle des voltages d'anode durent jusqu'à ce que les signaux de mesure i₁, i2, ..., iₙ soient égaux, ou en variante jusqu'à ce que les différences par paires des signaux de mesure i₁, i₂, ..., iₙ soient comprises dans la tolérance d'homogénéité demandée.
